# EUROPÄISCHE PATENTANMELDUNG

(11) **EP 0 980 172 A2**
(43) Veröffentlichungstag der Anmeldung: **16.02.2000**
(21) Anmeldenummer: 99113878.5
(22) Anmeldetag: 16.07.1999
(51) Int. Cl.: H04M 1/02

(54) **Türanlage, insbesondere Türsprechanlage**

(30) Priorität: 12.08.1998 DE 19836435
(71) Anmelder: Ritto - Werk Loh GmbH & Co. KG, 35708 Haiger (DE)
(72) Erfinder: Achenbach, Heinz, 35236 Breidenbach (DE)
(74) Vertreter: Fleck, Hermann-Josef, Dr.-Ing.

(57) **Zusammenfassung**

Die Erfindung betrifft eine Türanlage, insbesondere Türsprechanlage, mit einem Gehäuse mit einem Aufnahmeraum für mehrere Funktionseinheiten mit quadratischer Außenkontur, die in einem durch Zeilen und Spalten gebildeten Raster in das Gehäuse einsetzbar und darin gehalten sind. Ein ausreichend fester Halt der Funktionseinheiten im Gehäuse wird durch Festlegung der Funktionseinheiten auf der Rückseite einer gemeinsamen Frontplatte erreicht. Die Einheit aus Frontplatte und Funktionseinheiten wird in das Gehäuse eingesetzt und mit diesem verbunden.

## Beschreibung

Die Erfindung betrifft eine Türanlage, insbesondere Türsprechanlage, mit einem Gehäuse mit einem Aufnahmeraum für mehrere Funktionseinheiten mit quadratischer Außenkontur, die in einem durch Zeilen und Spalten gebildeten Raster in das Gehäuse einsetzbar und darin gehalten sind.

Derartige Türanlagen in sogenannter Modulbauweise sind in unterschiedlichen Ausgestaltungen bekannt, wie die FR-PS 21 22 912, die DE-OS 31 08 056 und die DE 40 19 837 C2 zeigen. Dabei ist für das Gehäuse oft ein beachtlicher Teileaufwand erforderlich und das Einsetzen sowie Auswechseln der Funktionseinheiten setzt umfangreiche Montagearbeiten voraus. Der Aufwand nimmt dabei sehr stark zu, wenn die Funktionseinheiten in Zeilen und Spalten zu einem Rasterfeld zusammengebaut werden. Außerdem ist der Halt der Funktionseinheiten im Gehäuse nicht immer ausreichend fest.

Es ist Aufgabe der Erfindung, eine Türanlage der eingangs erwähnten Art zu schaffen, bei der bei einfachem Gehäuseaufbau, d.h. minimalem Teile- und Montageaufwand, der Halt der Funktionseinheiten im Gehäuse verbessert wird.

Diese Aufgabe wird nach der Erfindung dadurch gelöst, daß die Funktionseinheiten auf allen Außenseitenwänden einen umlaufenden Haltesteg tragen, daß die offene Seite des boxartigen Gehäuses mittels einer gemeinsamen Frontplatte abdeckbar ist, die auf der dem Aufnahmeraum des Gehäuses zugekehrten Rückseite die Zeilen oder die Spalten abteilende Rasterstege aufweist, daß die Rasterstege den Zeilen oder Spalten zugekehrt mit Aufnahmenuten für den Haltesteg von Funktionseinheiten versehen sind, daß die Funktionseinheiten jeweils auf die beiden die Zeile oder die Spalte begrenzenden Rasterstege aufschiebbar und auf das Raster ausrichtbar sind, und daß die Frontplatte mit den aufgeschobenen Funktionseinheiten als Einheit in den Aufnahmeraum des Gehäuses einsetzbar und mit diesem verbindbar ist, oder in äquivalenter Weise dadurch, daß die Funktionseinheiten auf allen Außenseitenwänden eine umlaufende Haltenut tragen, daß die offene Seite des boxartigen Gehäuses mittels einer gemeinsamen Frontplatte abdeckbar ist, die auf der dem Aufnahmeraum des Gehäuses zugekehrten Rückseite die Zeilen oder die Spalten abteilende Rasterstege aufweist, daß die Rasterstege den Zeilen oder Spalten zugekehrt Haltestege tragen, die beim Aufschieben der Funktionseinheiten auf die die Zeile oder die Spalte begrenzenden Rasterstege in den Haltenuten der Funktionseinheiten geführt und gehalten sind, und daß die Frontplatte mit den aufgeschobenen und auf das Raster ausgerichteten Funktionseinheiten als Einheit in das Gehäuse einsetzbar und mit diesem verbindbar ist.

Die Frontplatte und die Funktionseinheiten können einfach als vorgefertigte Einheit in der gewünschten Anordnung zusammengebaut und dann in ein einfaches boxartiges Gehäuse eingesetzt und mit diesem verbunden werden. Dabei sind die Funktionseinheiten fest an der Frontplatte gehalten und können dennoch nach dem Herausnehmen der Einheit aus dem Gehäuse beim Austausch von der Frontplatte gelöst werden. Das Gehäuse ist einfach boxartig ausgebildet und wie die Frontplatte auf die Größe des Rasterfeldes abgestimmt.

Nach einer Ausgestaltung kann vorgesehen sein, daß die Rasterstege als T-Stege oder an den Rändern der Frontplatte als L-Stege ausgebildet sind, und daß die Rasterstege als getrennte Teile mittels Nut-Feder-Verbindung auf der Rückseite der Frontplatte befestigt oder einstückig an der Frontplatte angeformt sind, um die Rasterstege in dem durch die Außenkontur der Funktionseinheiten vorgegebenen Raster an der Frontplatte anzubringen.

Für die Befestigung der Einheit aus Frontplatte und Funktionseinheiten im Gehäuse kann nach einer Ausgestaltung vorgesehen sein, daß die Funktionseinheiten und das Gehäuse mittels hinterschnittener Nut-Feder-Verbindungen miteinander verbunden sind. Dabei ist die Anordnung vorzugsweise so, daß die hinterschnittenen Nut-Feder-Verbindungen zwischen der Außenseite der Bodenwand der Funktionseinheiten und der Innenseite der Bodenwand des Gehäuses angeordnet sind.

Bei einer abgenommenen Gehäuse-Seitenwand kann die Einheit dann in das Gehäuse eingeschoben werden. Mit dem Anbringen der Gehäusewand ist die Einheit unverschiebbar und nicht entnehmbar im Gehäuse gehalten.

Ist dabei zudem vorgesehen, daß die hinterschnittenen Nut-Feder-Verbindungen quer zu den Rasterstegen der Frontplatte verlaufen, dann werden die Funktionseinheiten auf den Rasterstegen nicht verschoben, wenn die Einheit in das Gehäuse eingeschoben wird.

Die Einheit aus Frontplatte und Funktionseinheiten kann jedoch auch auf andere Arten mit dem Gehäuse verbunden, z.B. verschraubt werden, wobei es genügt, die Frontplatte mit dem Gehäuse zu verschrauben.

Das Anbringen der Funktionseinheiten an der Frontplatte wird dadurch noch vereinfacht und erleichtert, daß die Rasterstege mit Einführöffnungen für als Ansätze ausgebildete Haltestege der Funktionseinheiten versehen sind, so daß die Funktionseinheiten senkrecht zur Frontplatte auf die Rasterstege aufsetzbar und durch Verschieben in der Frontplattenebene darauf festlegbar sind. In gleicher Weise kann dies auch bei vertauschten Verbindungselementen an der Frontplatte und den Funktionseinheiten erreicht werden.

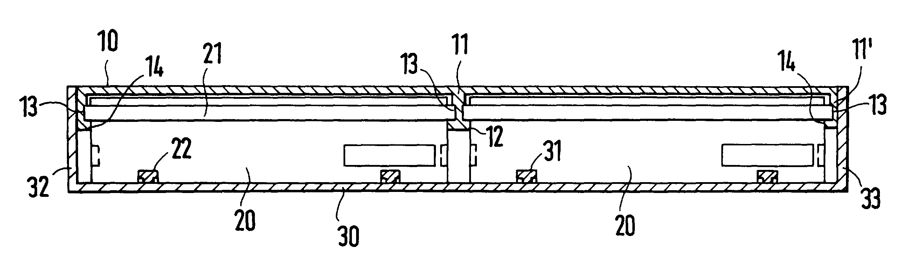

Die Erfindung wird anhand eines in der Zeichnung im Querschnitt dargestellten Ausführungsbeispiels näher erläutert.

Der Schnitt zeigt ein boxartiges, zur Frontseite hin offenes Gehäuse 30, das eine 2-zeilige oder 2-spaltige Rastereinheit aus Frontplatte 10 und daran festgelegten Funktionseinheiten 20 aufnimmt.

Im Ausführungsbeispiel sind auf der dem Gehäuse-Aufnahmeraum zugekehrten Rückseite Rasterstege 11 und 11' angeformt, die die Zeilen oder Spalten begrenzen. Die Rasterstege 11 sind als T-Stege und die im Randbereich der Frontplatte 10 verlaufenden Rasterstege 11' als L-Stege ausgebildet, die beidseitig oder nur einseitig Aufnahmenuten 13 für einen umlaufenden Haltesteg 21 der Funktionseinheiten 20 aufnehmen können. Die Aufnahmenuten 13 der Rasterstege 11 und 11' werden durch deren Querstege 12 und 14 vervollständigt. Es ist daher möglich, die Funktionseinheiten 20 in der Frontplattenebene auf die Rasterstege 11 und 11' aufzuschieben und so an der Frontplatte 10 festzuhalten und auf das Rasterfeld auszurichten.

Die so vormontierte Einheit aus der Frontplatte 10 und den Funktionseinheiten 20 wird in das Gehäuse 30 eingesetzt und darin festgelegt, d.h. mit dem Gehäuse 30 verbunden. Dies kann z.B. durch einfaches Verschrauben der Frontplatte 10 mit den Seitenwänden 32 und 33 des Gehäuses 30 erfolgen. Die Seitenwände 32 und 33 des Gehäuses 30 können sich auch direkt an die Rasterstege 11' anschließen und mit diesen verschraubt werden. Die Verbindungsstellen sind dann auf der Frontseite der Türanlage nicht sichtbar.

Die Rasterstege 11 und 11' können auch als separate Teile hergestellt und mit der Frontplatte 10 verbunden werden. Außerdem kann die Form der Rasterstege 11 und 11' geändert, sowie die Anordnung von Aufnahmenut und Haltesteg an den miteinander zu verbindenden Teilen vertauscht werden, um denselben Zweck zu erreichen.

Bei der bis jetzt beschriebenen Ausgestaltung werden die Funktionseinheiten 20 senkrecht zur Zeichenebene der Zeichnung auf die Rasterstege 11 und 11' aufgeschoben. Wenn sich die Rasterstege 11 und 11' in dieser Richtung über sehr viele Rasterteilungen erstreckt, dann ergeben sich große Verschiebewege. Dies kann dadurch vermieden werden, daß die Rasterstege 11 und 11' pro Rasterteilung mit Einführöffnungen für als Ansätze ausgebildete Haltestege 21 der Funktionseinheiten 20 versehen sind, so daß die Funktionseinheiten 20 im Bereich jedes Rasterfeldes senkrecht zur Frontplatte 10 auf die Rasterstege 11 und 11' aufgesetzt und durch Verschieben in der Frontplattenebene darauf festgelegt werden. Der Verschiebeweg kann daher sehr klein sein. Die Anordnung und die Anzahl der Einführöffnungen an den Rasterstegen 11 und 11' ist auf die Anordnung und die Anzahl der Ansätze an den Funktionseinheiten 20 abzustimmen. Diese vereinfachte Montage der Funktionseinheiten 20 an der Frontplatte 10 läßt sich auch bei vertauschten Verbindungselementen zwischen Frontplatte 10 und Funktionseinheit 20 erreichen. Darüberhinaus kann auch eine andere Form für die Rasterstege und Aufnahmenuten gewählt werden. Wesentlich ist nur, daß die Funktionseinheiten 20 auf der Rückseite der Frontplatte 10 senkrecht zur Frontplattenebene in den eingestellten Rasterpositionen nicht abnehmbar gehalten sind.

Da das Gehäuse 30 mit horizontal ausgerichteten Zeilen oder mit vertikal ausgerichteten Spalten befestigt werden kann, werden die Funktionseinheiten 20 einmal horizontal und zum anderen vertikal auf die Rasterstege 11 und 11' aufgeschoben. Damit die vertikale Ausrichtung der Funktionseinheiten 20 unabhängig davon beibehalten werden kann, sind die Haltestege 21 bzw. Aufnahmenuten auf allen vier Außenseitenwänden der Funktionseinheiten 20 angeordnet, so daß sie in zwei um 90° verdrehten Stellungen mit den Rasterstegen 11 und 11' verbindbar sind.

Wie der Schnitt weiter zeigt, können die mit der Frontplatte 10 gehaltenen Funktionseinheiten 20 mittels hinterschnittener Nut-Feder-Verbindungen im Gehäuse 30 zusätzlich festgelegt werden. Dabei sind in der Bodenwand der Funktionseinheiten 20 T-förmige Aufnahmenuten 22 eingeformt, die auf der Innenseite des Bodens des Gehäuses 30 angeformte T-Stege aufnehmen. Ist eine in der Zeichenebene liegende Gehäuseseitenwand des Gehäuses 30 abgenommen, dann kann die Einheit aus Frontplatte 10 und festgelegten Funktionseinheiten 20 als Einheit in das Gehäuse 30 eingeschoben werden, wobei zwischen den Funktionseinheiten 20 und dem Gehäuse 30 die hinterschnittenen Nut-Feder-Verbindungen 22-31 hergestellt werden.

Die Funktionseinheiten 20 können dabei mit senkrecht zueinander stehenden Aufnahmenuten 22 versehen sein, so daß die Ausrichtung der Rasterstege 11 und 11' wieder keine Rolle spielt. Außerdem kann auch für die Einheit aus Frontplatte 10 und Funktionseinheiten 20 ein verkürzter Verschiebeweg erreicht werden, wenn die T-Stege 31 des Gehäuses 30 mit Einführausnehmungen versehen sind und die Aufnahmenuten 22 nur im Bereich der Einführstellen durch Ansätze die T-Stege hintergreifen.

Ist die Einheit in das Gehäuse 30 eingeschoben, dann wird die offene Seite des Gehäuses 30 mit der Gehäuseseitenwand verschlossen, so daß die Einheit unverschiebbar und nicht entnehmbar in dem Gehäuse 30 gehalten ist. Die Gehäuseseitenwand kann dabei mit den Rasterstegen 11' verschraubt werden. Die im Schnitt gezeigten hinterschnittenen Nut-Feder-Verbindungen 22-31 verlaufen nicht senkrecht zur Zeichenebene sondern in derselben. Beim Einschieben der Einheit in das Gehäuse 30 und Aufschieben auf die T-Stege 31 werden dann die Funktionseinheiten 20 auf den Rasterstegen 11 und 11' nicht verstellt und behalten ihre Rasterposition bei.

## Patentansprüche

1. Türanlage, insbesondere Türsprechanlage, mit einem Gehäuse mit einem Aufnahmeraum für mehrere Funktionseinheiten mit quadratischer Außenkontur, die in einem durch Zeilen und Spalten gebildeten Raster in das Gehäuse einsetzbar und darin gehalten sind,
dadurch gekennzeichnet,
daß die Funktionseinheiten (20) auf allen Außenseitenwänden einen umlaufenden Haltesteg (21) tragen,
daß die offene Seite des boxartigen Gehäuses (30) mittels einer gemeinsamen Frontplatte (10) abdeckbar ist, die auf der dem Aufnahmeraum des Gehäuses (30) zugekehrten Rückseite die Zeilen oder die Spalten abteilende Rasterstege (11) aufweist,
daß die Rasterstege (11) den Zeilen oder Spalten zugekehrt mit Aufnahmenuten (13) für den Haltesteg (21) von Funktionseinheiten (20) versehen sind,
daß die Funktionseinheiten (20) jeweils auf die beiden die Zeile oder die Spalte begrenzenden Rasterstege (11) aufschiebbar und auf das Raster ausrichtbar sind, und
daß die Frontplatte (10) mit den aufgeschobenen Funktionseinheiten (20) als Einheit in den Aufnahmeraum des Gehäuses (30) einsetzbar und mit diesem verbindbar ist.

2. Türanlage, insbesondere Türsprechanlage, mit einem Gehäuse mit einem Aufnahmeraum für mehrere Funktionseinheiten mit quadratischer Außenkontur, die in einem durch Zeilen und Spalten gebildeten Raster in das Gehäuse einsetzbar und darin gehalten sind,
dadurch gekennzeichnet,
daß die Funktionseinheiten (20) auf allen Außenseitenwänden eine umlaufende Haltenut tragen,
daß die offene Seite des boxartigen Gehäuses (30) mittels einer gemeinsamen Frontplatte (10) abdeckbar ist, die auf der dem Aufnahmeraum des Gehäuses (30) zugekehrten Rückseite die Zeilen oder die Spalten abteilende Rasterstege (11) aufweist,
daß die Rasterstege (11) den Zeilen oder Spalten zugekehrt Haltestege tragen, die beim Aufschieben der Funktionseinheiten (20) auf die die Zeile oder die Spalte begrenzenden Rasterstege (11) in den Haltenuten der Funktionseinheiten (20) geführt und gehalten sind, und
daß die Frontplatte (10) mit den aufgeschobenen und auf das Raster ausgerichteten Funktionseinheiten (20) als Einheit in das Gehäuse (30) einsetzbar und mit diesem verbindbar ist.

3. Türanlage nach Anspruch 1 oder 2,
dadurch gekennzeichnet,
daß die Rasterstege (11) als T-Stege oder an den Rändern der Frontplatte (10) als L-Stege (11') ausgebildet sind.

4. Türanlage nach Anspruch 1 oder 2,
dadurch gekennzeichnet,
daß die Rasterstege (11) als getrennte Teile mittels Nut-Feder-Verbindung auf der Rückseite der Frontplatte (10) befestigt oder einstückig an der Frontplatte (10) angeformt sind.

5. Türanlage nach einem der Ansprüche 1 bis 4,
dadurch gekennzeichnet,
daß die Funktionseinheiten (20) und das Gehäuse (30) mittels hinterschnittener Nut-Feder-Verbindungen (22, 31) miteinander verbunden sind.

6. Türanlage nach Anspruch 5,
dadurch gekennzeichnet,
daß die hinterschnittenen Nut-Feder-Verbindungen (22, 31) zwischen der Außenseite der Bodenwand der Funktionseinheiten (20) und der Innenseite der Bodenwand des Gehäuses (30) angeordnet sind.

7. Türanlage nach Anspruch 5,
dadurch gekennzeichnet,
daß die hinterschnittenen Nut-Feder-Verbindungen (22, 31) quer zu den Rasterstegen (11) der Frontplatte (10) verlaufen.

8. Türanlage nach Anspruch 1,
dadurch gekennzeichnet,
daß die Rasterstege (11, 11') mit Einführöffnungen für als Ansätze ausgebildete Haltestege (21) der Funktionseinheiten (20) versehen sind, so
daß die Funktionseinheiten (20) senkrecht zur Frontplatte (10) auf die Rasterstege (11, 11') aufsetzbar und durch Verschieben in der Frontplattenebene darauf festlegbar sind.
